Europäisches Patentamt

European Patent Office

Office européen des brevets

(19)

(11) Veröffentlichungsnummer: **0 204 182 B1**

(12) **EUROPÄISCHE PATENTSCHRIFT**

(45) Veröffentlichungstag der Patentschrift: 05.06.91

(21) Anmeldenummer: 86106479.8

(22) Anmeldetag: 13.05.86

(51) Int. Cl.⁵: **H01L 21/316,** C23C 16 40

(54) **Verfahren zum Herstellen von mit Bor und Phosphor dotierten Siliziumoxid-Schichten für integrierte Halbleiterschaltungen.**

(30) Priorität: 22.05.85 DE 3518452

(43) Veröffentlichungstag der Anmeldung:
10.12.86 Patentblatt 86/50

(45) Bekanntmachung des Hinweises auf die
Patenterteilung:
05.06.91 Patentblatt 91/23

(84) Benannte Vertragsstaaten:
AT DE FR GB IT NL

(56) Entgegenhaltungen:
US-A- 4 105 810

JOURNAL OF THE ELECTROCHEMICAL SO-
CIETY, Band 126, Nr. 6, Juni 1979, Seiten
1042-1046, Manchester, New Hampshire, US;
A. ADAMS et al.: "The deposition of silicon
dioxide films at reduced pressure"

JOURNAL OF THE ELECTROCHEMICAL SO-
CIETY, Band 129, Nr. 7, Juli 1982, Seiten
1588-1592, Manchester, New Hampshire, US;
R.M. LEVIN et al.: "Low pressure deposition
of phosphosilicate glass films"

(73) Patentinhaber: **Siemens Aktiengesellschaft
Wittelsbacherplatz 2
W-8000 München 2(DE)**

(72) Erfinder: **Becker, Frank Stefan, Dr.
Neufriedenheimer Str. 67a
W-8000 München 70(DE)**
Erfinder: **Pawlik, Dieter, Dipl.-Ing.
Tölzer Strasse 20
W-8038 Gröbenzell(DE)**

## Beschreibung

Die Erfindung betrifft ein Verfahren zum Herstellen von mit Bor und Phosphor dotierten SiO$_2$-Schichten, wie sie bei der Herstellung von integrierten Halbleiterschaltungen als Zwischenschicht zur elektrischen Isolation und zum Ausgleich von topographischen Unebenheiten auf Substratscheiben verwendet werden, durch thermische Zersetzung von die Elemente enthaltenden gasförmigen Verbindungen.

Solche Schichten werden als Bor-Phosphor-Silikat-Glas (BPSG)-Schichten bezeichnet und werden dadurch hergestellt, daß Silan im Temperaturbereich zwischen 300 und 450$^\circ$ C oxidiert wird. Zur Erzeugung der Oxiddotierung werden dabei gleichzeitig Phosphin (PH$_3$) und Boran (B$_2$H$_6$) oder Bortrichlorid (BCl$_3$) zugesetzt. Der Prozeß kann sowohl im Plasma, bei Atmosphärendruck oder im Niederdruckbereich durchgeführt werden.

Abscheideverfahren bei Atmosphärendruck und im obengenannten Temperaturbereich mit Phosphin und Boran als Dotiergase sind beispielsweise aus der US-A-3.481.781 und aus einem Aufsatz von Kern und Schnable im RCA Review, Vol. 43, September 1982, Seiten 423 bis 457, zu entnehmen. US-A-4 105 810 beschreibt die Herstellung von mit Bor und Zink dotierten Siliziumoxid-Schichten durch thermische zersetzung von Alkyl- oder Alkoxid- Verbindungen von Zink, Bar und Silizium

Die Bor-Phosphor-Silikatglasschichten haben in ihrer An-Wendung als Zwischenoxidschicht zwischen den Polysiliziumebenen und der ersten Aluminiumleiterbahnebene bei der Herstellung von hochintegrierten MOS-Speichern folgende Funktionen zu erfüllen:

1. Das Zwischenoxid muß eine gute elektrische Isolation zwischen der Polysiliziumebene bzw. den Diffusionsgebieten und der Aluminiumleiterbahn gewährleisten.

2. Das Zwischenoxid muß die bis zur Polysiliziumstrukturierung entstandenen topographischen Unebenheiten auf dem Substrat ausgleichen bzw. verrunden.

Eine solche Verrundung ist notwendig, da der nachfolgende Aluminium-Sputterprozeß Abschattungseffekte aufweist und zu starke Stufen in der Unterlage Überhänge bzw. Abrisse der Aluminiumleiterbahnen bewirken können. Mit zunehmender Integration der Bauelemente wird dieses Problem immer kritischer, da aufgrund abnehmender lateraler Abmessungen bei gleichbleibenden Schichtdicken das Höhe/Breite-Aspektverhältnis zunimmt.

Da durch eine Optimierung des auf dem Prinzip der Chemical Vapour Deposition (CVD) beruhenden Oxid-Abscheideprozesses sich bestenfalls nur eine konforme, das heißt, keine zusätzlichen Überhänge aufweisende Kantenbedeckung erreichen läßt, ist es notwendig, den Zwischenoxidprozeß als eine Kombination von Schichtabscheidung und anschließender "Verfließung" zu konzipieren. Um einen solchen Verfließschritt bei prozeßtechnisch tragbaren Temperaturen durchführen zu können, muß das SiO$_2$ den Erweichungspunkt herabsetzende Zusätze enthalten. In der Praxis werden hier Phosphor bzw. Bor und Phosphor verwendet, die in Form ihrer Oxide bereits bei der Schichtabscheidung mit in die Zwischenoxidschicht eingebaut werden und sogenannte "ternäre" Gläser bilden. Der Phosphor hat dabei hauptsächlich die Funktion, die elektrische Stabilität der Schicht zu verbessern, während der Borgehalt die Verfließtemperatur bestimmt.

Die oben zum Stand der Technik genannten Prozesse zur Herstellung von Bor-Phosphor-Silkatglasschichten haben verschiedene Nachteile:

1. Diboran als Borlieferant ist giftig, explosiv und chemisch instabil. Dies führt dazu, daß der Diborangehalt der das Diborangasgemisch enthaltenden Gasflasche mit der Zeit sinkt und daß keine herkömmlichen Niederdruck-Gasphasenabscheidungs (Lowpressure Chemical Vapor Deposition = LPCVD)-Rohranlagen mit Injektoren verwendet werden können, da das Diboran sich in den Injektoren bereits erwärmt und zersetzt. Bortrichlorid andererseits führt zu einem Chloreinbau in die Schicht, wodurch ernste Korrosionsprobleme der nachfolgenden Metallisierung auftreten können.

2. Die chemische Stabilität gegenüber Luftfeuchtigkeit ist bei den dotierten Niedertemperaturoxiden generell schlecht; so bilden sich zum Beispiel schon bei Borkonzentrationen im Bereich von 3 bis 4 Gew% Ausscheidungen von Borsäure, wie aus dem eingangs erwähnten Bericht von Kern und Schnable aus dem RCA Review, Vol. 43, 1982, auf den Seiten 423 bis 457 zu entnehmen ist.

3. Der Phosphor liegt in den Niedertemperaturschichten zum Teil als P$_2$O$_3$, zum Teil als P$_2$O$_5$ vor, wobei nur der fünfwertige Phosphor für die Verfließung relevant ist.

4. Oxidprozesse auf Silan-Basis sind sehr empfindlich auf Lecks in der Abscheideanlage.

5. Die Kantenbedeckung der Niedertemperaturoxide ist generell nicht zufriedenstellend.

Aufgabe der Erfindung ist es daher, einen Bor-Phosphor-Silikatglas-Abscheideprozeß zu entwickeln, der die Nachteile teile der bisherigen Verfahrensweisen vermeidet.

Die erfindungsgemäße Aufgabe wird durch ein Verfahren der eingangs genannten Art dadurch gelöst, daß

a) als Ausgangsstoffe für die thermische Zersetzung die Verbindungen Tetraethylorthosilikat (-

(C₂H₅O)₄Si), Trimethylborat ((CH₃O)₃B) und Trimethylphosphat ((CH₃O)₃PO) verwendet werden,

b) die thermische Zersetzung der Verbindungen gleichzeitig oberhalb von 600°C in einem Niederdruck-Reaktor durchgeführt wird und

c) die Ausgangsstoffe über getrennte Verdampfer dem Reaktor zugeführt werden wobei die Bor und Phosphor enthaltenden Dotiergase und die SiO₂- Schicht bildende gasförmige Tetraäthylorthosilikat-Verbindung im Gegenstromprinzip in den Reaktor geleitet werden

Anstelle von Trimethylphosphat kann Phosphin (PH₃) mit Sauerstoff (O₂) gemischt verwendet werden, wobei das PH₃/O₂-Verhältnis größer 0,2 beträgt. Das Gasgemisch wird über einen Strömungsgeschwindigkeitsregler dem Reaktor zugeführt.

Weitere Ausgestaltungen der Erfindung ergeben sich aus den Unteransprüchen.

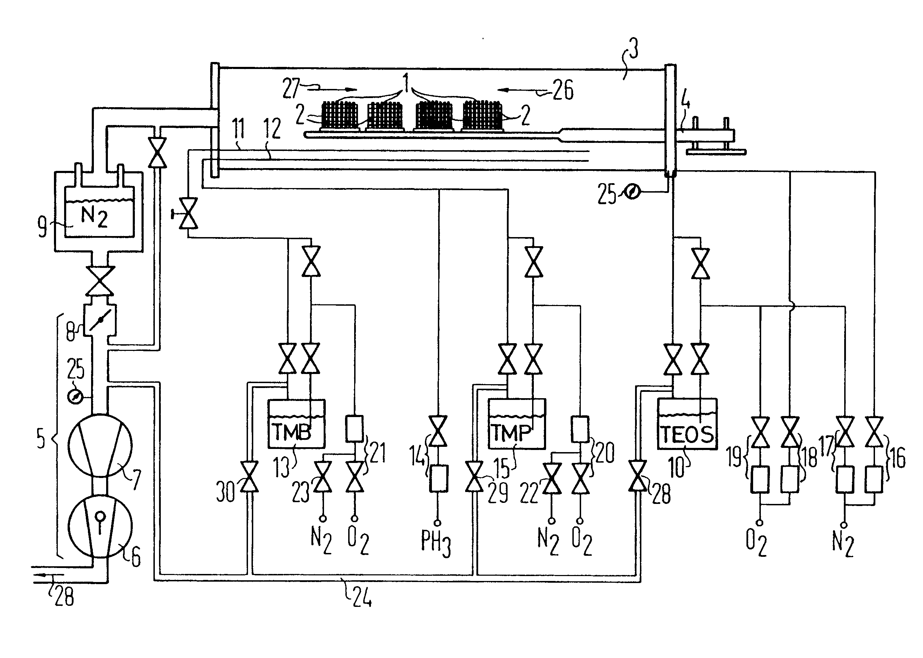

Anhand eines Ausführungsbeispiels und der in der Zeichnung befindlichen Figur soll im folgenden die Erfindung noch näher erläutert werden. Die Figur stellt im Schnittbild eine Vorrichtung dar, in der aus Silizium bestehende Halbleitersubstratscheiben 2 mit einer Bor-Phosphor-Silikatglasschicht versehen werden.

Die in den als Quarzkäfig ausgebildeten, als "Boote" bezeichneten Scheibenhalterungen 1 stehenden Siliziumscheiben 2 werden in einem im Handel erhältlichen (Heraeus Cantilever) Niederdruck-Abscheideofen 3 mittels einer Schiebevorrichtung 4 eingebracht. Durch einen Pumpstand 5, bestehend aus Vorpumpe 6, Wälzkolbenpumpe 7 und Regelventil 8 wird über eine Stickstoff-Kühlfalle 9 das Reaktionsrohr 3 evakuiert (siehe Pfeil 28) und dann die Prozeßgase, die zum Aufbau der auf den Substratscheiben 2 aufzubringenden BPSG-Schicht erforderlich sind, eingeleitet.

Das Tetraäthylorthosilikat (TEOS) wird in einem Verdampfer 10, der sich auf einer Temperatur im Bereich von 30 bis 60°C befindet, verdampft und an der Seite des Reaktors 3 in den Reaktor eingelassen (siehe Pfeil 26), an der auch die Substratscheiben (1, 2, 4) eingeführt werden. Die Dotiergase werden dagegen durch Injektoren 11, 12, (das sind mit Durchlässen versehene dünne Quarzrohre), von der entgegengesetzten Seite (siehe Pfeil 27) in den Reaktionsraum 3 eingeleitet.

Die Zufuhr des Bor-Dotiergases Tritmethylborat (TMB) erfolgt über den Verdampfer 13, der auf einer Temperatur im Bereich von 30 bis 60°C gehalten wird, während zur Phosphordotierung wahlweise Phosphingas (PH₃) über einen Strömungsgeschwindigkeitsmesser 14 oder Tritmethylphosphat (TMP) aus einem Verdampfer 15, der sich auf einer Temperatur größer 60°C, vorzugsweise bei 70°C befindet, verwendet werden kann.

Der Abscheidedruck im Reaktionsraum 3 wird im Bereich von 15-100 Pa (ca 100 bis 800 mTorr) eingestellt; das PH₃ O₂-Verhältnis beträgt größer 0,2. Als Abscheidetemperaturbereich wird 600 bis 700°C gewählt.

Durch zusätzliche Anschlußleitungen und Strömungsgeber mit Ventilen 16, 17, 18, 19, 20, 21, 22, 23 ist es möglich. Stickstoff (N₂) oder Sauerstoff (O₂) durch die Verdampfer 10, 13, 15 hindurchperlen zu lassen. Über eine Evakuierleitung 24 und die Ventile 29, 30, 28 sind die Verdampfer 10, 13, 15 mit dem Pumpstand 5 verbunden. Über die mit dem Bezugzeichen 25 bezeichneten Meßgeräte (Baratron) wird der Druck kontrolliert. Weitere, nicht mit Bezugszeichen versehene Symbole in der Zeichnung stellen Ventile für die einzelnen Zuleitungen dar.

Mit dem Verfahren nach der Lehre der Erfindung ist es möglich, BPSG-Schichten herzustellen. die - auch bei Konzentrationen im Bereich von 5:5 Gew% Bor Phosphor - in Umgebungsluft chemisch stabil sind und den Phosphor nur in Form von P₂O₅ enthalten. Bei einer den bisherigen BPSG-Verfahren entsprechenden Schichtdickenhomogenität weisen die erfindungsgemäßen Schichten eine sehr gute Kantenbedeckung auf. Die gewünschten Bor Phosphor-Konzentrationen lassen sich durch Variation der Zufuhr an Dotiergasen, sowie der Abscheidetemperaturen einstellen. Der Prozeß ist bezüglich Lecks unkritischer als Silan-Prozesse. Ein weiterer Vorteil ist dadurch gegeben, daß die Bordotierung über das ungiftige Trimethylborat erfolgt.

## Ansprüche

1. Verfahren zum Herstellen von mit Bor und Phosphor dotierten Siliziumoxid-Schichten, wie sie bei der Herstellung von integrierten Halbleiterschaltungen als Zwischenschichten zur elektrischen Isolation und zum Ausgleich von topographischen Unebenheiten auf Substratscheiben (2) verwendet werden. durch thermische Zersetzung von die Elemente enthaltenden gasförmigen Verbindungen, **dadurch gekennzeichnet,** daß

a) als Ausgangsstoffe (10, 13, 15) für die thermische Zersetzung die Verbindungen Tetraäthylorthosilikat ((C₂H₅O)₄Si). Trimethylborat ((CH₃O)₃B) und Trimethylphosphat ((CH₃O)₃PO) verwendet werden.

b) die thermische Zersetzung der Verbindungen gleichzeitig oberhalb von 600°C in einem Niederdruck-Reaktor (3) durchgeführt wird,

c) die Ausgangsstoffe (10, 13, 15) über getrennte Verdampfer dem Reaktor (3) zugeführt werden, wobei die Bor und Phosphor enthaltenden Dotiergase (11, 12) und die die SiO₂-Schicht bildende gasförmige Tetraäthylorthosilikatverbindung (10) im Gegenstromprinzip (26, 27) in den Reaktor (3) geleitet werden.

2. Verfahren nach Anspruch 1, **dadurch gekennzeichnet,** daß anstelle von Tritmethylphosphat (15) Phosphin (PH₃) mit Sauerstoff (O₂) gemischt verwendet wird, wobei das PH₃/O₂-Verhältnis größer 0,2 beträgt, und daß die Verbindung über einen Strömungsge-schwindigkeitsregler (14) dem Reaktor (3) zugeführt wird.

3. Verfahren nach Anspruch 1 oder 2, **dadurch gekennzeichnet,** daß der Druck im Reaktor (3) auf einen Bereich zwischen 15 bis 100 Pa eingestellt wird.

4. Verfahren nach mindestens einem der Ansprüche 1 bis 3, **dadurch gekennzeichnet,** daß die Temperatur im Reaktor (3) auf 600 bis 700° C eingestellt wird.

5. Verfahren nach mindestens einem der Ansprüche 1 bis 4, **dadurch gekennzeichnet,** daß die Verdampfertemperaturen von Tetraäthylorthosilikat (10) und Trimethylborat (13) auf einen Bereich von 30 bis 60° C und die Verdampfertemperatur von Trimethylphosphat (15) auf größer 60° C eingestellt wird.

6. Verfahren nach mindestens einem der Ansprüche 1 bis 5, **dadurch gekennzeichnet,** daß für die zu verdampfenden Verbindungen Trägergase, wie Stickstoff oder Sauerstoff, verwendet werden, die durch die Verdampfergefäße (10, 13, 15) geleitet werden.

## Claims

1. Process for producing silicon oxide layers, doped with boron and phosphorus, such as those used in producing integrated semiconductor circuits as intermediate layers for the electrical insulation and for smoothing out topographical irregularities on substrate wafers (2), by thermal decomposition of gaseous compounds containing the elements, characterised in that
   a) the compounds tetraethyl orthosilicate (-(C₂H₅O)₄Si), trimethyl borate ((CH₃O)₃B) and trimethyl phosphate ((CH₃O)₃PO) are used as starting substances (10, 13, 15) for the thermal decomposition,
   b) the thermal decomposition of the compounds is carried out simultaneously above 600° C in a lowpressure reactor (3),
   c) the starting substances (10, 13, 15) are supplied via separate evaporators to the reactor (3), the doping gases (11, 12) containing boron and phosphorus and the gaseous tetraethyl orthosilicate compound (10) forming the SiO₂ layer being fed into the reactor (3) on the countercurrent principle (26, 27).

2. Process according to Claim 1, characterised in that, instead of trimethyl phosphate (15), phosphine (PH₃) is mixed with oxygen (O₂), the PH₃/O₂ ratio being greater than 0.2, and in that the compound is supplied to the reactor (3) via a flow rate regulator (14).

3. Process according to Claim 1 or 2, characterised in that the pressure in the reactor (3) is adjusted to a range of between 15 and 100 Pa.

4. Process according to at least one of Claims 1 to 3, characterised in that the temperature in the reactor (3) is adjusted to 600 to 700° C.

5. Process according to at least one of Claims 1 to 4, characterised in that the tetraethyl orthosilicate (10) and trimethyl borate (13) evaporator temperatures are adjusted to a range of 30 to 60° C and the trimethyl phosphate (15) evaporator temperature up to greater than 60° C.

6. Process according to at least one of Claims 1 to 5, characterised in that carrier gases, such as nitrogen or oxygen, which are fed through the evaporator vessels (10, 13, 15) are used for the compounds to be evaporated.

## Revendications

1. Procédé pour fabriquer des couches d'oxyde de silicium dopées par du bore et du phosphore, du type utilisées pour la fabrication de circuits à semiconducteurs en tant que couches intermédiaires pour l'isolation électrique et la compensation d'inégalités topographiques sur des disques formant substrats (2), par décomposition thermique de composés gazeux contenus dans les éléments, caractérisé par le fait que
   a) on utilise comme substances de départ (10,13,15) pour la décomposition thermique, les composés orthosilicate de tétraéthyle, (-(C₂H₅O)₄Si), du triméthylborate ((CH₃O)₃B) et du trimethylphosphate ( (CH₃O)₃PO),
   b) on exécute la décomposition thermique des composés simultanément à une température supérieure à 600°C dans un réacteur à basse pression (3),

c) on envoie les substances de départ (10,13,15), par l'intermédiaire d'évaporateurs séparés, au réacteur (3), tandis que les gaz dopants (11,12), qui contiennent du bore et du phosphore, et le composé gazeux (10) d'orthosilicate de tétraéthyle, qui forme la couche de SiO$_2$, sont introduits dans le réacteur (3) selon le principe à contre-courant (26,27).

2. Procédé suivant la revendication 1, caractérisé par le fait qu'à la place de triméthylphosphate (15), on utilise de la phosphine (PH$_3$) mélangée à de l'oxygène (O$_2$), le rapport PH$_3$/O$_2$ étant supérieur à 0,2, et qu'on envoie le composé au réacteur (3) par l'intermédiaire d'un régulateur (14) de la vitesse d'écoulement.

3. Procédé suivant la revendication 1 ou 2, caractérisé par le fait qu'on règle la pression dans le réacteur (3) dans une gamme comprise entre 15 et 100 Pa.

4. Procédé suivant au moins l'une des revendications 1 à 3, caractérisé par le fait qu'on règle la température dans le réacteur (3) entre 600 et 700°C.

5. Procédé suivant au moins l'une des revendications 1 à 4, caractérisé par le fait qu'on règle les températures des évaporateurs pour l'orthosilicate de tétraéthyle (10) et le triméthylborate (13) dans une gamme comprise entre 30 et 60°C et la température de l'évaporateur pour le triméthylphosphate (15) à une valeur supérieure à 60°C.

6. Procédé suivant au moins l'une des revendications 1 à 5, caractérisé par le fait qu'on utilise, pour les composés devant être évaporés, des gaz porteurs tels que l'azote ou l'oxygène, qu'on fait circuler dans les enceintes (10,13,15) des évaporateurs.

EP 0 204 182 B1